# EUROPEAN PATENT APPLICATION

(11) **EP 3 767 692 A1**
(43) Date of publication of application: **20.01.2021**
(21) Application number: 20173845.7
(22) Date of filing: 11.05.2020
(51) Int. Cl.: H01L 43/04, H01L 43/08, H01L 43/12, G11C 11/16

(54) **STRUCTURE OF MEMORY DEVICE AND METHOD FOR FABRICATING MEMORY DEVICE**

(30) Priority: 19.07.2019 CN 201910654128
(71) Applicant: United Microelectronics Corp., Hsinchu (TW)
(72) Inventor: WANG, Runshun, 541317 Singapore (SG); ZHU, Mengkai, 541258 Singapore (SG); MA, Zhuona, 510407 Singapore (SG); LEE, Hua-Kuo, 519492 Singapore (SG)
(74) Representative: Becker, Eberhard

(57) **Abstract**

The invention discloses a structure of a memory device. The structure includes a substrate, having a memory region and a logic region. A barrier layer is disposed on the substrate, covering the memory region and the logic region. A patterned inter-layer dielectric layer is disposed on the barrier layer only at the memory region. A first via structure is formed in the barrier layer and the patterned inter-layer dielectric layer at the memory region. A memory cell structure is disposed on the patterned inter-layer dielectric layer at the memory region, in contact with the first via structure. An interconnection structure is disposed on the barrier layer at the logic region.

## Description

### BACKGROUND OF THE INVENTION

### 1. Field of the Invention

The present invention relates to a semiconductor fabricating technique, in particular, to a structure of a memory device and a method for fabricating a memory device.

### 2. Description of Related Art

Non-volatile memory devices are almost essential in digital electronic products. The digital electronic products such as computers, mobile phones, cameras, video recorders, etc. are also indispensable products in daily life. Therefore, non-volatile memories are always required. The storage density of the memory device is also expected to be increased in response to storage of a large amount of digital data. Reduction of the usage area of the memory device is a consideration in design, research and development.

There may be a variety of different designs for the structure of a memory cell of the non-volatile memory, and there are different structures for different storage methods. To save a device area, a memory cell of a sandwich stack structure has been provided, which includes a memory material layer sandwiched between an upper electrode layer and a lower electrode layer. In accordance with the characteristics of the memory material layer, such memory, may be, for example, a variable resistive memory device, that has two stable resistance values according to the control of an applied voltage by use of resistance variation characteristics of a memory material, so that the memory may be configured to store one bit of data.

The overall fabrication of the memory device of the sandwich structure includes fabrication of various devices at a memory region and a logic region. The memory cell is fabricated and formed in the memory region, and a control device is fabricated and formed in the logic region and is configured to operate the memory cell.

Since some dielectric material layers may be shared in the memory region and the logic region, and desired devices are respectively fabricated in the two regions, a patterning process including lithography and etching may be involved, which may possibly cause remaining of conductive materials. Long-time operation may cause improper bridge connection between the devices, resulting in the reduced performance or damage of the devices.

How to design the structure of the memory device and reduce residues produced during fabrication is a problem to be considered in the research and development process.

### SUMMARY OF THE INVENTION

The present invention provides a structure of a memory device and a method for fabricating a memory device. In a process of fabricating various devices of a memory region and a logic region, after a memory cell is fabricated at the memory region, the present invention may effectively reduce metal residues at the logic region and at least may prolong the service life of the devices at the logic region.

According to one embodiment, the present invention provides a structure of a memory device. The structure of the memory device includes a substrate, having a memory region and a logic region. A barrier layer is disposed on the substrate and covers the memory region and the logic region. A patterned inter-layer dielectric layer is disposed on the barrier layer only at the memory region. A first via structure is formed in the barrier layer and the patterned inter-layer dielectric layer at the memory region. A memory cell structure is disposed on the patterned inter-layer dielectric layer at the memory region, in contact with the first via structure. An interconnection structure is disposed on the barrier layer at the logic region.

According to one embodiment, for the structure of the memory device, the patterned inter-layer dielectric layer being disposed on the barrier layer only at the memory region is formed by removing a portion of an initial inter-layer dielectric layer of the patterned inter-layer dielectric layer by lithography and etching processes to expose the barrier layer in the logic region.

According to one embodiment, for the structure of the memory device, the substrate includes: a silicon substrate; a dielectric layer, disposed on the silicon substrate; and a contact structure, disposed in the dielectric layer and in contact with the bottom of the first via structure.

According to one embodiment, for the structure of the memory device, the barrier layer is an oxygen-free dielectric material layer, and covers the contact structure.

According to one embodiment, for the structure of the memory device, the memory cell structure is of a stack structure, and includes a memory material layer sandwiched between a lower electrode layer and an upper electrode layer.

According to one embodiment, for the structure of the memory device, the memory cell structure includes a resistive memory cell structure, a phase change memory cell structure or a magnetoresistive memory cell structure.

According to one embodiment, the structure of the memory device further includes a spacer wall on the side wall of the stack structure.

According to one embodiment, the structure of the memory device further includes: a dielectric layer, covering the memory cell structure at the memory region; and a memory cell connection layer, disposed in the dielectric layer, in contact with the memory cell structure.

According to one embodiment, the structure of the memory device further includes: a dielectric layer, disposed on the barrier layer. The interconnection structure is formed in the dielectric layer. The interconnection structure includes: a second via structure, disposed in the barrier layer and the dielectric layer; and an interconnection layer, disposed in the dielectric layer, in contact with the top of the second via structure in the dielectric layer.

According to one embodiment, for the structure of the memory device, the dielectric layer includes a material with an ultra-low dielectric constant.

According to one embodiment, the present invention further provides a method for fabricating a memory device, including: providing a substrate having a memory region and a logic region; forming a barrier layer and an inter-layer dielectric layer on the substrate in sequence, covering the memory region and the logic region; forming a first via structure in the barrier layer and the inter-layer dielectric layer at the memory region; forming a memory cell structure on the inter-layer dielectric layer at the memory region, in contact with the first via structure; patterning the inter-layer dielectric layer to remove a portion of the inter-layer dielectric layer to expose a portion of the barrier layer at the logic region; and forming an interconnection structure on the barrier layer at the logic region.

According to one embodiment, for the method for fabricating a memory device, the substrate provided includes: a silicon substrate; a dielectric layer, disposed on the silicon substrate; and a contact structure, disposed in the dielectric layer and in contact with the bottom of the first via structure.

According to one embodiment, for the method for fabricating a memory device, the barrier layer is formed by an oxygen-free dielectric material layer, and covers the contact structure.

According to one embodiment, for the method for fabricating a memory device, the memory cell structure is of a stack structure, and includes a memory material layer sandwiched between a lower electrode layer and an upper electrode layer.

According to one embodiment, for the method for fabricating a memory device, the memory cell structure includes a resistive memory cell structure, a phase change memory cell structure or a magnetoresistive memory cell structure.

According to one embodiment, the method for fabricating a memory device further includes forming a spacer wall on the side wall of the stack structure.

According to one embodiment, the method for fabricating a memory device further includes: forming a dielectric layer covering the memory cell structure at the memory region; and forming a memory cell connection layer in the dielectric layer, in contact with the memory cell structure.

According to one embodiment, for the method for fabricating a memory device, the dielectric layer includes a material with an ultra-low dielectric constant.

According to one embodiment, for the method for fabricating a memory device further includes: forming a dielectric layer on the barrier layer. The interconnection structure is formed in the dielectric layer. The interconnection structure includes: a second via structure, disposed in the barrier layer and the dielectric layer; and an interconnection layer, disposed in the dielectric layer, in contact with the top of the second via structure.

According to one embodiment, for the method for fabricating a memory device, the dielectric layer includes a material with an ultra-low dielectric constant.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 is a schematic diagram of a structure of a memory device according to one embodiment of the present invention.
FIG. 2 is a structural schematic diagram of a memory cell according to one embodiment of the present invention.
FIG. 3 is a schematic diagram of a structure of a memory device according to one embodiment of the present invention.
FIGs. 4 to 5 are cross-sectional structural schematic diagrams of a memory device in a fabricating process according to one embodiment of the present invention.
FIG. 6 is a flow diagram of a method for fabricating a memory device according to one embodiment of the present invention.

### DESCRIPTION OF THE EMBODIMENTS

The present invention relates to a structure of a memory device. The structure of a non-volatile memory device is conventionally, for example, a structure of a flash memory that utilizes stored charges to store data. However, in consideration of increasing the density of a memory, another structure of a memory cell having a sandwich structure has also been provided, which may increase the density of memory cells.

The basic architecture of the memory cell of the sandwich structure is that a memory material layer is sandwiched between an upper electrode layer and a lower electrode layer. The size of a resistor is changed by the change in a physical state of the memory material layer, so that the data may be stored. The memory cell of this sandwich structure is, for example, a resistive Random Access Memory (ReRAM), a phase change RAM (PCRAM), or a magnetoresistive RAM (MRAM).

A plurality of embodiments is provided below to describe the present invention, but the present invention is not limited to the embodiments. The embodiments may also be combined properly.

The overall fabrication of a memory device includes fabrication of different devices at a memory region and a logic region. A memory cell is fabricated and formed in the memory region, while, for example, a control device is fabricated and formed in the logic region and is configured to operate the memory cell. Respective fabrications of corresponding devices at the two regions involve a shared structural layer or fabricating process.

In a general fabricating process, various stack layers may be formed at the memory region and the logic region together, such as various stacked layers including a barrier layer, an inter-layer dielectric layer and a sandwich stack of memory cell. Thereafter, a patterning process including lithography and etching is performed on the sandwich stack layer at the memory region to complete the sandwich structure of the memory cell at first. In addition, at the logic region, an interconnection structure is at least formed on the basis of the inter-layer dielectric layer.

The present invention is firstly looking into a prototype of a memory device to find some possible defects to further provide a solution.

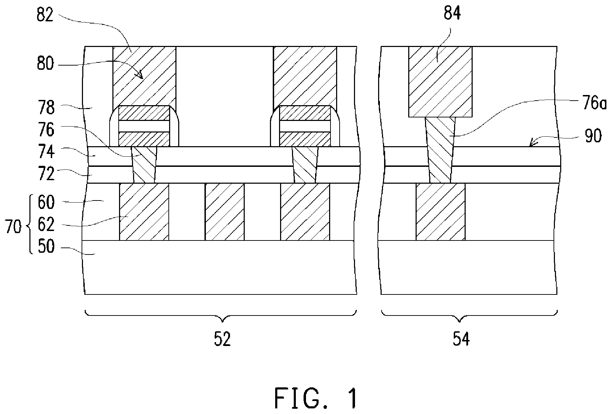

FIG. 1 is a schematic diagram of a structure of a memory device according to one embodiment of the present invention. A silicon substrate 50 is used as a basis for the device. A memory region 52 and a logic region 54 are planned on the silicon substrate 50. Some devices may be formed on the silicon substrate 50, which includes, for example, a transistor device. The transistor device may be connected upwards through a contact structure 62 in a dielectric layer 60, so as to be subsequently connected to a memory cell. In one embodiment here, a substrate 70 refers to a structural body including, for example, the silicon substrate 50, the dielectric layer 60 and the contact structure 62, and thereafter a memory cell 80 is continuously formed.

The substrate 70 has corresponding structures corresponding to the memory region 52 and the logic region 54, and detailed descriptions are omitted herein. Thereafter, a barrier layer 72 shared by the memory region 52 and the logic region 54 may be formed on the substrate 70. The contact structure 62 is of, for example, a metal material, such as copper or tungsten, which is not limited. The barrier layer 72 is, for example, an oxygen-free electrical material that covers the contact structure 62 to prevent the contact structure 62 from being infiltrated by oxygen to cause oxidation.

An inter-layer dielectric layer 74 is also formed on the barrier layer 72 in response to the needs of via structures 76, 76a. The inter-layer dielectric layer 74 is, for example, an oxide or a plasma enhanced (PE) oxide. The via structure 76 at the memory region 52 is in contact connection with the contact structure 62, which may achieve a path for upward connection to the memory cell 80. The via structure 76 at the logic region 54 is in contact connection with the contact structure 62 to achieve a path for external connection of a control device at the logic region 54.

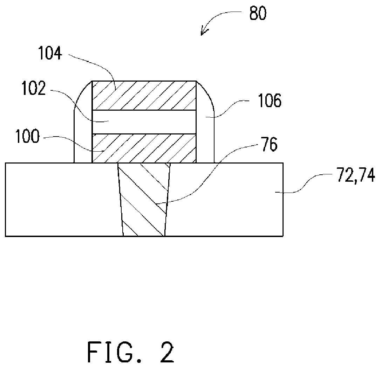

Thereafter, fabrication of the structure of the memory cell 80 is completed at the memory region 52. The structure of the memory cell 80 will be described in detail in FIG. 2. After the fabrication of the memory cell 80 is completed on the inter-layer dielectric layer 74, the via structure 76a may be also formed at the logic region 54. Next, another layer of interconnection structures 82, 84 are also respectively formed at the memory region 52 and the logic region 54 to achieve desired paths. The dielectric layer 78 is a support structure that needs to be formed during the formation of the interconnection structures 82, 84 in accordance with a semiconductor fabricating technique. That is, the dielectric layer 78 is another inter-layer dielectric layer, which is not described in detail as generally known. The present invention does not limit these subsequently formed devices.

The desired interconnection structure 84 may also be formed at the logic region 54, and is in contact connection with the via structure 76a. The dielectric layer 78 may be shared or respectively formed at the memory region 52 and logic region 54. In consideration of the fabrication cost, the dielectric layer 78 and the interconnection structures 82, 84 are completed, for example, at both the memory region 52 and the logic region 54 under the same fabricating process.

FIG. 2 is a structural schematic diagram of a memory cell according to one embodiment of the present invention. Referring to FIG. 2, the basic structure of the memory cell 80 of a sandwich structure is a stack structure composed of an upper electrode layer 104, a memory material layer 102 and a lower electrode layer 100. The lower electrode layer 100 may be in contact connection with the top of the via structure 76. In addition, a spacer wall 106 is disposed on the side wall of the stack structure to protect the memory cell 80. The memory cell 80 may be, for example, a resistive memory cell structure, a phase change memory cell structure or a magnetoresistive memory cell structure in accordance with different material characteristics of the memory material layer 102.

After looking into the structure of FIG. 1, it is found that the inter-layer dielectric layer 74 is a shared layer at the memory region 52 and the logic region 54 in the fabricating process. When the memory cell 80 is fabricated at the memory region 52, its initial metal material layer configured to, for example, form electrodes, may also be deposited on the inter-layer dielectric layer 74 at the logic region 54. During the formation of the memory cell 80, although various material layers at the logic region 54 may be removed by the patterning process including lithography and etching, some residues of metal configured to form the electrodes and the like may possibly remain on the surface 90 of the inter-layer dielectric layer 74. These residues of metal, for example, may possibly cause improper bridge connection between devices after a period of time of use, resulting in reduction of the life of the devices.

After looking into the structure of the memory device of FIG. 1 and the process of fabricating the memory device, a modification of a modified fabricating process is further provided, which may effectively prevent improper residues on the surface 90 of the inter-layer dielectric layer 74 and at least improve the quality of the memory device.

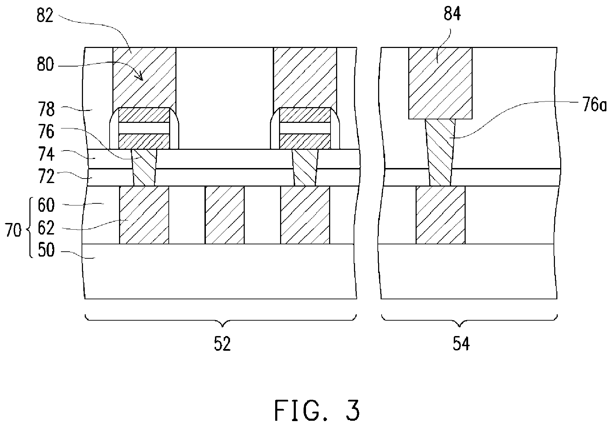

FIG. 3 is a schematic diagram of a structure of a memory device according to one embodiment of the present invention. Referring to FIG. 3, the structure is similar to the structure of a memory device of FIG. 1, but a patterned inter-layer dielectric layer 74 obtained by removing a portion of an inter-layer dielectric layer 74 at the logic region 54 through a patterning process covers the memory region 52 only, so that the logic region 54 is exposed by the inter-layer dielectric layer 74. That is, after the memory cell 80 is completed at the memory region 52, the portion of the inter-layer dielectric layer 74 at the logic region 54 may be removed at first, and then a dielectric layer 78, a via structure 76a and an interconnection structure 84 are continuously formed in the logic region 54. In one embodiment, the dielectric layer 78 may adopt a material with an ultra-low dielectric constant. Generally, the dielectric constant of silicon oxide is 4. The ultra-low dielectric constant refers to a range much less than the dielectric constant of the silicon oxide, and is, for example, a dielectric constant equal to or less than 2.5, and for another example, a dielectric constant equal to or less than 2.2. The material with the ultra-low dielectric constant may also be achieved by generating a porous structure in addition to selection of material components. The present invention does not limit the material of the dielectric layer 78.

Since the surface 90 of the inter-layer dielectric layer 74 at the logic region 54 is removed at first, as shown in FIG. 1, residues of metal on the surface 90 have been removed, and improper bridge connection between devices may be effectively prevented.

That is, in the structure of a memory device of FIG. 3, the portion of the inter-layer dielectric layer 74 at the logic region 54 is, for example, removed by a patterning process. This structure is favourable for preventing the improper bridge connection between the devices.

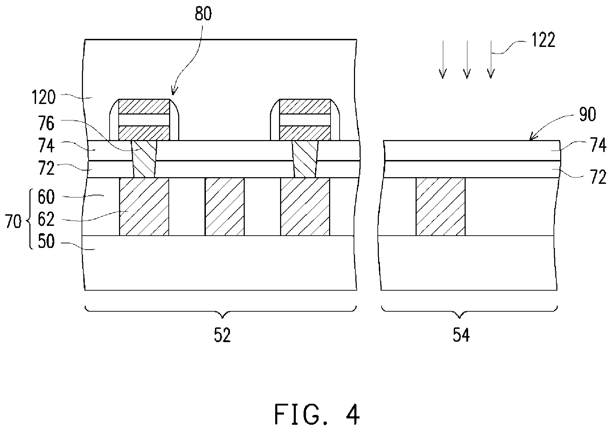

In the aspect of the fabricating flow, FIGs. 4 to 5 are cross-sectional structural schematic diagrams of a memory device in a fabricating process according to one embodiment of the present invention. Referring to FIG. 4, a barrier layer 72 and an inter-layer dielectric layer 74 which are completed on a memory region 52 and a logic region 54 are formed on a substrate 70 in sequence. At the memory region 52, a via structure 76 is formed in the barrier layer 72 and the inter-layer dielectric layer 74, and is in contact connection to a contact structure 62 in the substrate 70. A memory cell 80 is also formed at the memory region 52.

The memory cell 80 includes a lower electrode layer, a memory material layer and an upper electrode layer. Initial material layers of the various layers of the memory cell 80 may also be simultaneously deposited on the inter-layer dielectric layer 74 at the logic region 54. An undesired portion is removed through a patterning process required for the structure of the memory cell 80 to be formed, and lithography and etching processes may be involved.

In this case, materials related to the lower electrode layer, the memory material layer and the upper electrode layer in the logic region 54 have been removed. It is observed after looking into of the present invention that there may still be residues of metal on the surface 90 of the inter-layer dielectric layer 74, and the residues of metal may possibly cause bridge connection between devices.

In the present invention, the inter-layer dielectric layer 74 at the logic region 54 is removed, so that the residues on the surface 90 are also effectively removed. That is, the inter-layer dielectric layer 74 is patterned to remove the inter-layer dielectric layer 74 at the logic region 54. According to the fabrication, in one embodiment, a photoresist layer 120 is formed at first to cover the memory region 52 and expose the portion of the inter-layer dielectric layer 74 at the logic region 54. An etching process 122 is performed to etch the inter-layer dielectric layer 74 at the logic region 54.

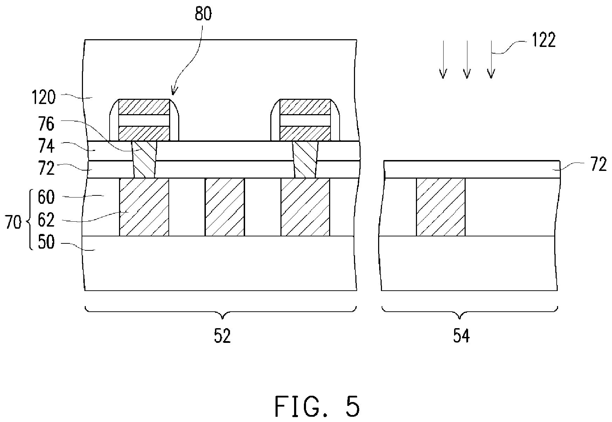

Referring to FIG. 5, after the etching process 122 is performed, the inter-layer dielectric layer 74 at the logic region 54 is removed to expose the barrier layer 72 at the logic region 54. In this way, the residues of metal remaining on the surface 90 are removed. Thereafter, subsequent structures such as via structures 76, 76a and interconnection structures 82, 84 at the memory region 52 and the logic region 54 as shown in FIG. 3 may be completed according to a general process of fabricating a semiconductor. The present invention does not limit specific subsequent structures.

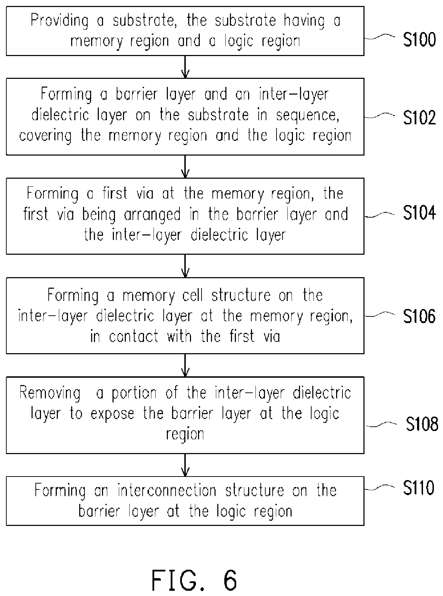

In the aspect of the overall fabrication, FIG. 6 is a flow diagram of a method for fabricating a memory device according to one embodiment of the present invention. Referring to the structures of FIG. 6 and FIGs. 3 to 5, in Step S100, a substrate 70 is provided. The substrate 70 has a memory region 52 and a logic region 54. In Step S102, a barrier layer 72 and an inter-layer dielectric layer 74 are formed on the substrate 70 in sequence, covering the memory region and the logic region. In Step S104, a first via structure 76 is formed at the memory region 52. The first via structure 76 is disposed in the barrier layer 72 and the inter-layer dielectric layer 74. In Step S106, a memory cell structure 80 is formed on the inter-layer dielectric layer 74 at the memory region 52, in contact with the first via structure 76. In Step S108, the inter-layer dielectric layer 74 is patterned to remove a portion of the inter-layer dielectric layer 74 to expose a portion of the barrier layer 72 at the logic region 54. In Step S110, an interconnection structure 84 is formed on the barrier layer 72 at the logic region 52.

According to the structure of the memory device and the method for fabricating the memory device, provided by the present invention, the memory cell 80 at the memory region 52 may be performed according to the predetermined patterning process to obtain the structure of the memory cell 80. Thereafter, the inter-layer dielectric layer 74 is patterned at the logic region 54 to remove the surface 90 possibly having the residues of metal. In this way, the probability of reducing bridge connection between conductive devices subsequently formed at the logic region 54 may be ensured. According to the technique of the present invention, practical verification shoes that an effect of effectively prolonging the service life of the devices is achieved.

## Claims

1. A structure of a memory device, comprising:
a substrate (70), comprising a memory region (52) and a logic region (54);
a barrier layer (72), disposed on the substrate and covering the memory region and the logic region;
a patterned inter-layer dielectric layer (74), disposed on the barrier layer only at the memory region (52);
a first via structure (76), formed in the barrier layer and the patterned inter-layer dielectric layer (74) at the memory region;
a memory cell structure (80), disposed on the patterned inter-layer dielectric layer (74) at the memory region (52), in contact with the first via structure (76); and
an interconnection structure (84), disposed on the barrier layer at the logic region (54).

2. The structure of the memory device according to claim 1, wherein the patterned inter-layer dielectric layer being disposed on the barrier layer only at the memory region is formed by removing a portion of an initial inter-layer dielectric layer of the patterned inter-layer dielectric layer by lithography and etching processes to expose the barrier layer in the logic region.

3. The structure of the memory device according to claim 1, wherein the substrate comprises:
a silicon substrate (50);
a dielectric layer (60), disposed on the silicon substrate; and
a contact structure (62), disposed in the dielectric layer and in contact with the bottom of the first via structure.

4. The structure of the memory device according to claim 2, wherein the barrier layer is an oxygen-free dielectric material layer, and covers the contact structure.

5. The structure of the memory device according to claim 1, wherein the memory cell structure is of a stack structure, and comprises a memory material layer sandwiched between a lower electrode layer and an upper electrode layer.

6. The structure of the memory device according to claim 5, wherein the memory cell structure comprises a resistive memory cell structure, a phase change memory cell structure or a magnetoresistive memory cell structure.

7. The structure of the memory device according to claim 5, further comprising a spacer wall on the side wall of the stack structure.

8. The structure of the memory device according to claim 1, further comprising:
a dielectric layer, disposed on the barrier layer, wherein the interconnection structure is formed in the dielectric layer;
the interconnection structure comprising:
a second via structure, disposed in the barrier layer and the dielectric layer; and
an interconnection layer, disposed in the dielectric layer, in contact with the top of the second via structure.

9. A method for fabricating a memory device, comprising:
providing a substrate (70) provided with a memory region (52) and a logic region (54);
forming a barrier layer (72) and an inter-layer dielectric layer (74) on the substrate in sequence, covering the memory region (52) and the logic region (54);
forming a first via structure (76) in the barrier layer (72) and the inter-layer dielectric layer (74) at the memory region (52);
forming a memory cell structure (80) on the inter-layer dielectric layer at the memory region (52), in contact with the first via structure;
patterning the inter-layer dielectric layer (74) to remove a portion of the inter-layer dielectric layer to expose a portion of the barrier layer (72) at the logic region; and
forming an interconnection structure (84) on the barrier layer (72) at the logic region.

10. The method for fabricating the memory device according to claim 9, wherein the substrate provided comprises:
a silicon substrate (50);
a dielectric layer (60), disposed on the silicon substrate; and
a contact structure, disposed in the dielectric layer and in contact with the bottom of the first via structure (62).

11. The method for fabricating the memory device according to claim 9, wherein the barrier layer is formed by an oxygen-free dielectric material layer, and covers the contact structure.

12. The method for fabricating the memory device according to claim 9, wherein the memory cell structure is of a stack structure, and comprises a memory material layer sandwiched between a lower electrode layer and an upper electrode layer.

13. The method for fabricating the memory device according to claim 12, wherein the memory cell structure comprises a resistive memory cell structure, a phase change memory cell structure or a magnetoresistive memory cell structure.

14. The method for fabricating the memory device according to claim 12, further comprising: forming a spacer wall on the side wall of the stack structure.

15. The method for fabricating the memory device according to claim 9, further comprising:
forming a dielectric layer on the barrier layer, wherein the interconnection structure is formed in the dielectric layer;
the interconnection structure comprising:
a second via structure, disposed in the barrier layer and the dielectric layer; and
an interconnection layer, disposed in the dielectric layer, in contact with the top of the second via structure.
